# EUROPEAN PATENT SPECIFICATION

(11) **EP 4 148 977 B1**
(45) Date of publication and mention of the grant of the patent: **02.07.2025**
(21) Application number: 21196074.5
(22) Date of filing: 10.09.2021
(51) Int. Cl.: H02P 29/00

(54) **SYSTEM AND METHOD FOR OBTAINING AN ESTIMATED OUTPUT POWER OF AN ELECTRIC MOTOR**
SYSTEM UND VERFAHREN ZUR GEWINNUNG EINER GESCHÄTZTEN AUSGANGSLEISTUNG EINES ELEKTROMOTORS
SYSTÈME ET PROCÉDÉ PERMETTANT D'OBTENIR UNE PUISSANCE DE SORTIE ESTIMÉE D'UN MOTEUR ÉLECTRIQUE

(43) Date of publication of application: 15.03.2023
(73) Proprietor: ABB SCHWEIZ AG, 5400 Baden (CH)
(72) Inventor: ORMAN, Maciej, 32-052 Radziszow (PL); JANNASCH, Steven, 02170 Espoo (FI)
(74) Representative: Maiwald GmbH

(56) References cited:
- CN-B- 110 632 512
- US-A1- 2009 119 036
- US-B1- 6 199 018

## Description

### FIELD OF THE INVENTION

The invention pertains to systems and methods for obtaining an estimated output power of an electric motor.

### BACKGROUND

Accurate output power measurements or estimations are important in the field of electric motors. As an example, acquiring accurate power readings enables users to spot possibilities where energy efficiency can be improved, for example by either renewing the motor or introducing a drive. An accurate output power also provides users with information about the process that the electric motor is driving. Furthermore, the output power may also be used for controlling the motor itself or other components of the process it is driving.

In principle, the output power can be estimated by measuring the voltage or current of the motor or, alternatively, using a torque meter. However, the required sensors may require a lot of installation effort because they need to have access to components of the motor or other components involved in the industrial process in which the electrical motor is used. Some potentially suitable sensors are also expensive. Document CN 110 632 512 B discloses a system for obtaining an estimated output power of an electric motor according to the preamble of claim 1.

Accordingly, a problem underlying the invention is to provide systems and methods for reliably obtaining an estimated output power of an electric motor with reduced effort for installation and/or reduced costs.

### SUMMARY

The problem is solved by the subject-matter of the independent claims. Preferred embodiments are laid down in the dependent claims.

The invention provides a system for obtaining an estimated output power of an electric motor. The system comprises a processing unit configured to obtain the estimated output power by performing an output power estimation on the basis of data measured by condition monitoring sensors, the data including vibration measurement data and magnetic flux density measurement data.

The advantage of using vibration measurement data and magnetic flux density measurement data is that they can be measured relatively easily and yet allow for a high-precision estimation of the output power.

Thus, the invention allows for high-precision output power estimation of electric motors that does not require other, more difficult to obtain, measurement values, for example, the current and voltage of the motor or torque, thereby reducing cost and effort for integration of the estimation in the industrial process.

Specifically, the condition monitoring sensors may be attached to the housing of the electric motor, e.g., by means of a clamping mount. More specifically, the sensors may be arranged in a common housing, which in turn may be attached, for example using a clamping mount, to the housing of the electric motor. Integration of current or voltage measurements or torque measurements is much more difficult, as they require actual access to at least part of the motor or components functionally connected with the motor.

Output power, in the context of this disclosure, refers to the mechanical output power of the electric motor.

The system may, in particular, be configured such that non-invasive and/or unobtrusive measurements are sufficient to provide all the measurement data used for the output power estimation. For example, no electrical connections with any of the motor components may be required.

The system may be configured to provide the estimated output power to a display device, which may be part of the system or may be external to the system, the display device configured to display a representation of the estimated output power.

Alternatively or in addition, the system, in particular the processing unit, may be configured to use the estimated output power for a subsequent calculation and/or to use the estimated output power for controlling the electric motor and/or to use the estimated output power for controlling other components involved in the industrial process in which the electric motor is used and/or to save the estimated output power in a memory device and/or to raise an alarm in response to the estimated output power exceeding a first predetermined threshold and/or being below a second predetermined threshold.

The processing unit may be configured to perform the output power estimation only on the basis of the vibration measurement data and magnetic flux density measurement data and/or data derived from the vibration measurement data and magnetic flux density measurement data.

The advantage of this is that these values can be easily measured and more difficult measurements can be entirely omitted, while at the same time a high-precision estimate can be obtained.

In particular, the processing unit may be configured to perform the output power estimation without measuring or using measurement values for current, voltage, and torque of the electric motor. Omitting the steps involved in obtaining these values reduces cost and effort to a great degree.

The processing unit may be configured to estimate speed values and line frequency values from the vibration measurement data and magnetic flux density measurement data, so as to obtain estimated speed values and estimated line frequency values, and to perform the output power estimation on the basis of at least some of the estimated speed values and at least some of the estimated line frequency values.

The advantage of this is that methods for estimation of speed values and line frequency values, as such, are already known and well-understood, thereby providing a reliable basis for the output power estimation.

More specifically, the magnetic flux density and vibration measurement data may be used to estimate a pair of values, i.e., an estimated speed value and an estimated line frequency value. This pair of values represents the operating point at a given time. It is to be understood that each of the pair of estimated values is estimated from magnetic flux density and vibration measurement data at said given time.

The estimation of speed and line frequency from the vibration measurement data and magnetic flux density measurement data may be performed using methods that are known to the person skilled in the art. Specifically, the line frequency can be derived from the magnetic flux density measurement data and speed can, for example be derived from the vibration measurement data.

The speed of the electric motor is the speed at which the rotor of the motor rotates and may be expressed in RPM or Hz. The line frequency is the dominant frequency at which the voltage and current in the stator coils oscillate.

The processing unit may be configured to use data associated with speed values and line frequency values obtained from historical measurements to determine whether any of the estimated speed values and estimated line frequency values are unreliable. The processing unit may further be configured to discard the speed values and line frequency values determined to be unreliable. In particular, the processing unit may be configured to determine whether any pairs of an estimated speed value and an estimated line frequency value are unreliable and discard any pairs determined to be unreliable.

The processing unit may in particular be configured to establish, particularly in an adaptive manner, a relation of speed values and line frequency values obtained from historical measurements to a parameter indicative of the strength of a magnetic flux density signal, for example a magnetic flux density root mean square, MFDRMS, or an amplitude of the dominant frequency, and, based on the relation, determine whether any of the speed values and line frequency values, particularly whether any of the pairs are unreliable.

The processing unit may be configured to perform the output power estimation on the basis of at least some of the estimated speed values and at least some of the estimated line frequency values that remain after discarding any of the speed values and line frequency values determined to be unreliable.

The above allows for improving accuracy of the output power estimation. Using indirect methods, like the one described above, for an estimation may introduce additional error sources compared to more direct measurement or estimation methods. However, by discarding some values on the basis of historical measurements may allow for eliminating or alleviating at least some of these additional error sources.

Finding unreliable operating points (outliers) in the above manner is advantageous because it is possible to reliably measure of magnetic flux density, and, accordingly, reliable determine variables derived therefrom, whereas the determination of speed and line frequency, and the rotor electrical frequency derived therefrom, has a degree of uncertainty. This is especially valid for motors supplied by variable frequency drives (VFD).

Historical measurements may be any measurements performed in advance of the current measurements, particularly measurements performed with the same or a similar electric motor,
Establishing the relation in an adaptive manner may comprise repeatedly updating the relation based on new measurement data combined with previously available (historical) measurement data.

Discarding values, e.g. of the speed and line frequency values, as unreliable will be described in more detail below. Expressed generally, the discarding may rely on an expectation and, when a deviation of newly obtained values from the expectation exceeds a certain threshold, the newly obtained values may be determined to be unreliable and discarded. The expectation may take the form of target values for the speed and line frequency values and/or a target value for a parameter indicative of the strength of the magnetic flux density signal.

The processing unit may be configured to determine whether any of the estimated speed values and estimated line frequency values are unreliable. Determining whether any of the estimated speed values and estimated line frequency values are unreliable may comprise, for a pair of an estimated speed value and an estimated line frequency value, calculating a value of a/the parameter indicative of the strength of a/the magnetic flux density signal, e.g. a/the magnetic flux density root mean square, MFDRMS, or an/the amplitude of the dominant frequency, from the estimated line frequency value and comparing the calculated value of the parameter indicative of the strength of the magnetic flux density signal with an expected value of the parameter indicative of the strength of the magnetic flux density signal for a speed value and a line frequency value that are the same as the estimated speed value and the estimated line frequency value.

The processing unit may, for example, be configured to determine a/the expected value of the parameter indicative of the strength of the magnetic flux density signal based on the relation.

Determining whether any of the estimated speed values and estimated line frequency values are unreliable may comprise determining the difference between the calculated value of the parameter indicative of the strength of the magnetic flux density signal and the expected value of the parameter indicative of the strength of the magnetic flux density signal and, upon determining that the difference exceeds a given threshold, determining that the estimated speed value and estimated line frequency value are unreliable.

In other words, the processing unit may be configured to discard outliers among pairs of speed values and line frequency values based on an expectation for a parameter that is indicative of the strength of the magnetic flux density signal for a given pair of speed values and line frequency values. As seen above, the parameter indicative of the strength of the magnetic flux density signal may comprise a magnetic flux density root mean square, MFDRMS, or an amplitude of the dominant frequency, for example.

The determining whether any of the estimated speed values and estimated line frequency values are unreliable as described in the present disclosure may, in particular, be performed for all pairs of an estimated speed value and an estimated line frequency value, and all pairs determined to be unreliable may be discarded.

The determination that speed values and line frequency values are unreliable can be understood as a classification of the speed values and line frequency values as unreliable.

The step of determining whether values are reliable may be seen as a verification step that verifies data to be used in the estimation of the output power. The discarding of any values having been identified as unreliable can be seen as a filtering step that filters out unreliable data from the data to be used in the estimation of the output power.

To summarize, historic values for a parameter indicative of the strength of the magnetic flux density signal and their corresponding historic pairs of speed value and line frequency value may be used to obtain an expectation of the value for this parameter for a given pair of speed value and line frequency value. The expectation may be used to determine whether a currently obtained pair of speed value and line frequency value is likely to be reliable or not and to discard any unreliable pairs of speed value and line frequency value.

Discarding or filtering out values improves the accuracy of the output power estimation.

The processing unit may be configured to perform the output power estimation by means of a mathematical model of the electric motor that models the output power based on speed values and line frequency values. In other words, the mathematical model may model the output power as a function of the operating point consisting of line frequency and speed information. From the measured operating point as an input, the mathematical model may output a value of the estimated output power.

Such mathematical models may be determined in an empirical or semi-empirical manner for a given electric motor, optionally combined with other models for this build of electric motor or similar builds of electric motors, which may be stored in and accessed using a database, and may have been provided by the manufacturer of the motor.

The processing unit may be configured to determine whether a/the mathematical model of the electric motor that models the output power based on speed values and line frequency values is available. The processing unit may be configured to, if it is determined that a mathematical model of the electric motor that models the output power based on speed values and line frequency values is available, perform the output power estimation by means of the mathematical model by inputting the at least some of the estimated speed values and the at least some of the estimated line frequency values into the mathematical model.

The processing unit may be configured to, if it is determined that no mathematical model of the electric motor that models the output power based on speed values and line frequency values is available, perform the output power estimation using an equation describing a relationship between a line frequency and the output power of the motor. In particular, the equation may describe a relationship between line frequency, speed, and output power of the electric motor. More specifically, the equation may take into account line frequency, speed, nominal line frequency, and nominal speed.

The latter may advantageously provide a fallback position in case no model is available. The estimation may be less precise in this case, but it will still be valuable, and, particularly, may serve as a temporary solution until a mathematical model becomes available. Lack of availability may sometimes only be a question of temporary lack of access to the model and the above steps may serve as a safety measure to ensure that this will not lead to the system becoming incapable of making any estimation.

The processing unit may be configured to regularly check the availability of a mathematical model of the electric motor, for example by querying one or more databases providing mathematical models of electric motors.

The processing unit may be configured to determine the above-mentioned relation of speed values and line frequency values obtained from historical measurements to the parameter indicative of the strength of a magnetic flux density signal, e.g., magnetic flux density root mean square, MFDRMS, or amplitude of the dominant frequency, by performing a plurality of measurements to obtain a plurality of speed values and line frequency values, determining corresponding magnetic flux density values, and performing a fitting step to obtain the parameter indicative of the strength of the magnetic flux density signal as a function of speed and line frequency. The processing unit configured may be configured to determine a/the expected value of the parameter indicative of the strength of the magnetic flux density signal based on the relation.

For example, a surface may be fitted to describe the relation of speed values and line frequency values obtained from historical measurements to the parameter indicative of the strength of a magnetic flux density signal, particularly magnetic flux density root mean square, MFDRMS, or amplitude of the dominant frequency.

The above-described steps of determining of values as being unreliable may be performed by determining whether, for a pair of estimated speed and line frequency values, the parameter indicative of the strength of the magnetic flux density signal, e.g. the magnetic flux density root mean square, MFDRMS, or the amplitude of the dominant frequency, is removed from the surface by more than a given amount, and any such pairs of values may be determined as unreliable. These values may then be discarded, as described above.

As can be seen above, the relation between speed values and line frequency values and the parameter indicative of the strength of the magnetic flux density signal, e.g. magnetic flux density root mean square, MFDRMS, or the amplitude of the dominant frequency, may be performed for use of the relation in subsequent output power estimation.

The invention also provides a computer-implemented method for obtaining an estimated output power of an electric motor, wherein the estimated output power is obtained by performing an output power estimation on the basis of data measured by condition monitoring sensors, the data including vibration measurement data and magnetic flux density measurement data.

The method may comprise performing the output power estimation only on the basis of the vibration measurement data and magnetic flux density measurement data and/or data derived from the vibration measurement data and magnetic flux density measurement data.

The method described in this disclosure may be performed by any of the systems described in this disclosure, specifically by the processing unit of the system and, where applicable, the condition monitoring sensors.

The method may comprise estimating speed values and line frequency values from the vibration measurement data and magnetic flux density measurement data, so as to obtain estimated speed bales and estimated line frequency values, and performing the output power estimation on the basis of at least some of the estimated speed values and at least some of the estimated line frequency values.

The method may comprise using data associated with speed values and line frequency values obtained from historical measurements to determine whether any of the estimated speed values and estimated line frequency values are unreliable and discarding the speed values and line frequency values determined to be unreliable, particularly determining whether any pairs of an estimated speed value and an estimated line frequency value are unreliable and discard any pairs determined to be unreliable.

In particular, the method may comprise establishing, particularly in an adaptive manner, a relation of speed values and line frequency values obtained from historical measurements to a parameter indicative of the strength of a magnetic flux density signal, for example a magnetic flux density root mean square, MFDRMS, or an amplitude of the dominant frequency, and, based on the relation, determining whether any of the speed values and line frequency values are unreliable, particularly whether any of the pairs are unreliable.

The output power estimation may be performed on the basis of at least some of the estimated speed values and at least some of the estimated line frequency values that remain after discarding the speed values and line frequency values determined to be unreliable.

The method may comprise determining whether any of the estimated speed values and estimated line frequency values are unreliable. Determining whether any of the estimated speed values and estimated line frequency values are unreliable may comprise, for a pair of an estimated speed value and an estimated line frequency value, calculating a value of a/the parameter indicative of the strength of a/the magnetic flux density signal, e.g. a/the magnetic flux density root mean square, MFDRMS, or an/the amplitude of the dominant frequency, from the estimated line frequency value and comparing the calculated value of the parameter indicative of the strength of the magnetic flux density signal with an expected value of the parameter indicative of the strength of the magnetic flux density signal for a speed value and a line frequency value that are the same as the estimated speed value and the estimated line frequency value.

The method may comprise determining a/the expected value of the parameter indicative of the strength of the magnetic flux density signal based on the above-mentioned relation.

In particular, determining whether any of the estimated speed values and estimated line frequency values are unreliable may comprise determining the difference between the calculated value of the parameter indicative of the strength of the magnetic flux density signal and the expected value of the parameter indicative of the strength of the magnetic flux density signal and, upon determining that the difference exceeds a given threshold, determining that the estimated speed value and estimated line frequency value are unreliable.

The determining whether any of the estimated speed values and estimated line frequency values are unreliable as described in the present disclosure may, in particular, be performed for all pairs of an estimated speed value and an estimated line frequency value, and all pairs determined to be unreliable may be discarded.

The method may comprise determining whether a/the mathematical model of the electric motor that models the output power based on speed values and line frequency values is available.

If it is determined that a mathematical model of the electric motor that models the output power based on speed values and line frequency values is available, the output power estimation may be performed by means of the mathematical model by inputting the at least some of the estimated speed values and the at least some of the estimated line frequency values into the mathematical model.

If it is determined that no mathematical model of the electric motor that models the output power based on speed values and line frequency values is available, the output power estimation may be performed using an equation describing a relationship between a line frequency and the output power of the motor.

Determining the relation of speed values and line frequency values obtained from historical measurements to the parameter indicative of the strength of a magnetic flux density signal comprises performing a plurality of measurements to obtain a plurality of speed values and line frequency values, determining corresponding magnetic flux density values, and performing a fitting step to obtain the parameter indicative of the strength of the magnetic flux density signal as a function of speed and line frequency. As mentioned above, determining an/the expected value of the parameter indicative of the strength of the magnetic flux density signal based on the above-mentioned relation.

The method may comprise displaying a representation of the estimated output power on a display device and/or using the estimated output power for a subsequent calculation and/or using the estimated output power for controlling the electric motor and/or using the estimated output power for controlling other components, for example other components involved in the industrial process in which the motor is used, and/or saving the estimated output power in a memory device and/or raising an alarm in response to the estimated output power exceeding a first predetermined threshold and/or being below a second predetermined threshold.

The invention also provides a computer program product comprising instructions which, when the program is executed by a computer, cause the computer to carry out any of the above methods.

The invention also provides a computer-readable medium comprising instructions which, when executed by a computer, cause the computer to carry out the method of any of the above methods.

The features and advantages outlined above in the context of the system similarly apply to the methods, the computer program product, and computer-readable medium described herein.

Further features, examples, and advantages will become apparent from the detailed description making reference to the accompanying drawings.

### BRIEF DESCRIPTION OF THE DRAWINGS

In the accompanying drawings,
Figure 1 illustrates a schematic representation of an exemplary system;
Figure 2 illustrates a schematic representation of a system including sensors and attached to an electric motor;
Figure 3 illustrates a flowchart of an exemplary method; and
Figure 4 illustrates a surface fitted to historical measurement data.

### DETAILED DESCRIPTION

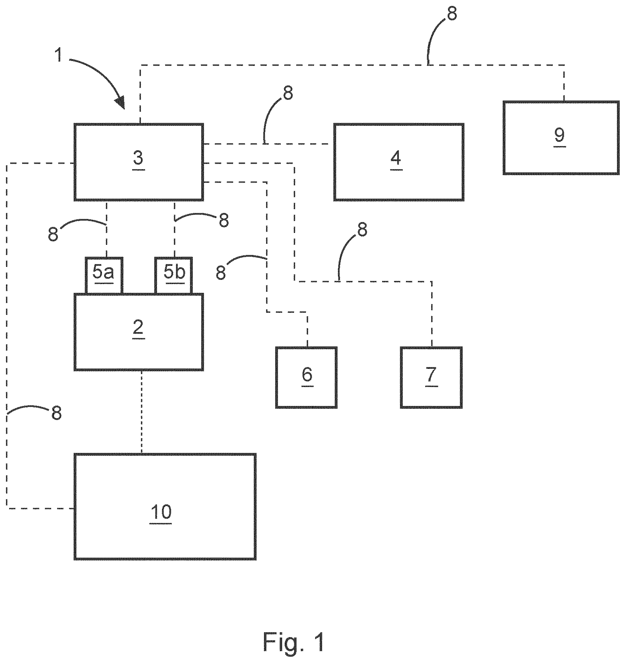

Figure 1 illustrates a system 1 for obtaining an estimated output power of an electric motor 2. The system comprises a processing unit 3. It may, for example, also comprise a memory unit 4. The motor may optionally be part of the system or may be external to the system.

The processing unit is configured to obtain the estimated output power by performing an output power estimation on the basis of data measured by condition monitoring sensors 5a and 5b, the data including vibration measurement data and magnetic flux density measurement data. The sensors may be part of the system 1 or external to the system 1.

The sensor 5a may be a vibration sensor and sensor 5b may be a magnetic flux density sensor. The skilled person would have at their disposal sensors known in the art that are suitable as the vibration sensor and the magnetic flux density sensor.

The system may further comprise or have access to at least one database 6 wherein historic measurement data and/or thresholds are stored, which may be used for determining unreliable values, also referred to as outliers. The system may further comprise or have access to at least one database 7 wherein one or more models that model the output power of an electric motor based on speed values and line frequency are stored. Optionally, rather than the models being stored in a separate database, they may be stored in the at least one database 6 wherein historic measurement data and/or thresholds. are stored, together with the historic measurement data and/or thresholds.

Database 6 and/or database 7 may optionally (not shown here) be stored in the memory unit 4.

The processing unit 3 may be configured to perform at least some of, in particular all of, the calculations involved in obtaining the estimated output power. The processing unit may be connected via data connections 8 to one or more of the memory unit 4, sensors 5a and 5b, database 6 and database 7, and may be configured to obtain, via the data connections, any data required for performing the calculations. The processing unit may also provide functionality to serve as a control device configured to control the electric motor and/or other components of an industrial process in which the motor is used, particularly on the basis of the estimated output power. Alternatively or in addition, the processing unit may be configured to provide the estimated output power to a control device 10 external to the processing unit and configured to control the electric motor and/or other components, particularly on the basis of the estimated output power. The control device may be part of or external to the system 1.

The system may comprise or be connected to a display device 9 configured to display a representation of the estimated output power. The processing unit may be connected to the display device via data connection 8 to provide the estimated output power to the display device.

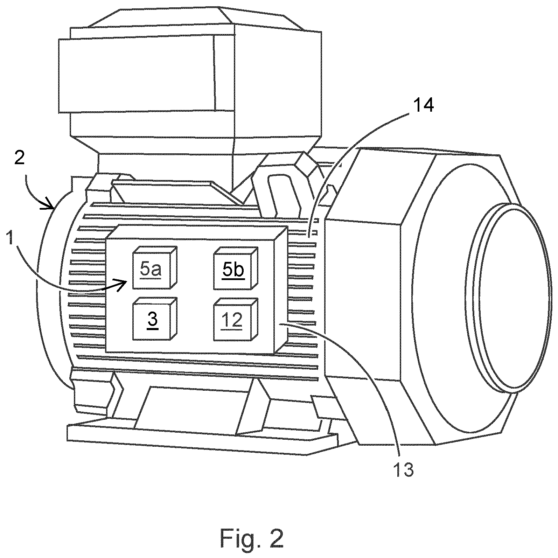

Figure 2 illustrates a system 1 including the processing unit 3, sensors 5a and 5b, and a communication interface 12 for transmitting and receiving data. As can be seen, the system is included in a housing 13 and attached to a housing 14 of the electric motor 2. For example, it may be attached by means of a clamping device (not shown). It may also be attached to the electric motor in any other suitable manner.

It can be immediately seen from the Figure that integrating the system for estimating the output power is very simple and does not require accessing the inside of the electric motor or establishing any electrical connections with the electric motor.

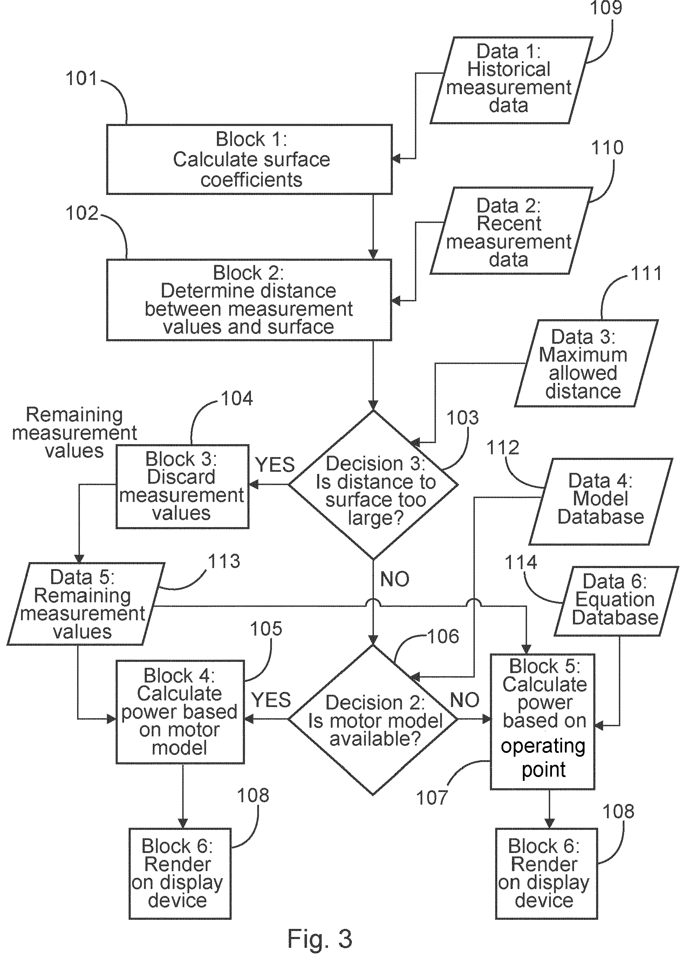

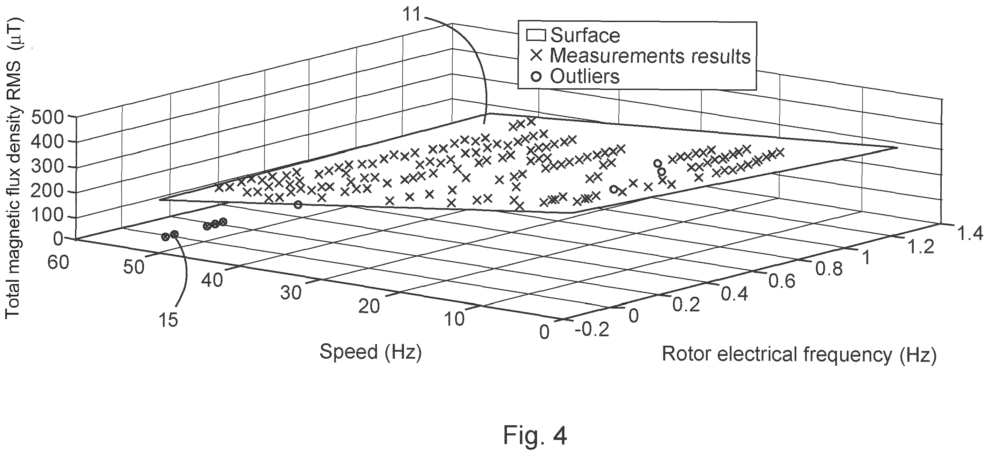

An exemplary method will be described below making reference to Figures 3 and 4, wherein Figure 3 is a block diagram illustrating different steps of the method, grouped into blocks or stages.

It is noted that the method according to the invention is defined by the independent method claim. The method may comprise only some of the blocks and decisions outlined below and/or it may comprise additional steps. It may comprise modifications of the blocks and decisions outlined below. The order of the blocks and decisions outlined below may be different.

Block 1, indicated by reference sign 101, describes method steps that optionally may be performed in preparation for the calculation of estimated output power.

The input, Data 1, consists of historical measurement data, e.g., from multiple measurements taken over a longer period. Block 1 entails finding the relation between operating points (consisting of speed and line frequency) and MFDRMS or other parameters derived from the magnetic flux density. Based on this relation, later steps may verify operating points for which the power can be reliably estimated.

The principle behind finding the relation between the operating points and the MFDRMS is to fit a MFDRMS surface to the estimated operating points. The surface is fitted using three measured parameters which may all be measured by the condition monitoring sensors using magnetic flux density and vibration measurements. The three measured parameters are the rotor electrical frequency, rotational speed, and MFDRMS. In place of MFDRMS, any other parameter indicative of the strength of the magnetic flux density signal, e.g., the amplitude of the dominant frequency, may be used. It is noted that the rotor electrical frequency may be calculated from the line frequency and the speed of the motor

Figure 4 illustrates an exemplary surface 11 fitted to historical measurement data, wherein outliers are indicated with circles 15. The MFDRMS depends on the operating point, i.e., the speed and rotor electrical frequency of the motor. The rotor electrical frequency is affected by the load of the motor. In other words, a certain operating point always has approximately the same MFDRMS value. Different operating points likely have different MFDRMS values. In the present example, a low rotor electrical frequency and low speed, the MFDRMS value is at its highest. It decreases with increasing rotor electrical frequency. In addition, the MFDRMS decreases with increasing speed.

Block 2, indicated by reference sign 102, and Decision 1, indicated by reference sign 103, describe method steps that optionally may be performed in preparation for the actual step of calculating the estimated output power on the basis of current measurement data, more specifically, steps in preparation for discarding unreliable data points. Block 2 takes in a recent measurement data (Data 2) and compares it to the surface generated by Block 1, which uses the historical measurement data (Data 1).

The steps of Block 2 and Decision 1 are optional, but they will improve the accuracy of the estimation if included in the method.

Finding unreliable operating points (outliers) with the help of the surface provided by Block 1 is possible because the sensor can reliably measure the MFDRMS, but the speed and rotor electrical frequency measurements have a degree of uncertainty. This is especially valid for motors supplied by variable frequency drives (VFD). If the speed and rotor electrical frequency are wrong, the MFDRMS is still measured correctly. By comparing the calculated MFDRMS with the expected MFDRMS given by the surface based on the measured speed and rotor electrical frequency, we can determine if the MFDRMS fits the surface or not. If it does not fit, i.e., the difference between the measured MFDRMS and the expected MFDRMS is too great, the speed and/or the rotor electrical frequency were measured incorrectly, and the measurement can be classified as an outlier.

Block 3, indicated by reference sign 104, describes method steps that optionally may be performed in preparation for the calculation of estimated output power on the basis of current measurement data, more specifically, steps in preparation for discarding unreliable data points. These steps are optional, but they will improve the accuracy of the estimation if included in the method.

Block 3 includes the step of discarding any operating point measurement if it was classified as an outlier. Estimating the output power of this unreliably estimated operating point would yield an inaccurate result. The quality of the system is improved because the number of low accuracy output power estimates is decreased.

Block 4, indicated by reference sign 105, and Decision 2, indicated by reference sign 106, describe the actual steps of estimating the power output on the basis of current measurement data, i.e., current measurement values, excluding any discarded measurement values (Data 5).

The output power may be calculated based on the mathematical model of the motor, if available. It may not always be guaranteed that a mathematical model is available. The method may comprise the optional Decision 2, which checks if there is a mathematical model available. For example, models may be stored, e.g. based on the serial number of the motor, in a Model Database (Data 4). If the model is available, Data 5, i.e., current measurement values excluding discarded measurement values, is given to Block 4 and the output power is calculated based thereon.

Optional Block 5, indicated by reference sign 107, describes the steps taken in case the method comprises Decision 2 and Decision 2 determines that no mathematical model of the motor is available. The output power, as specified in Block 5, may then be estimated using a common equation which, for example, may be based on the operating point and the nameplate parameters of the motor. To do so, Block 5 may receive Data 5 and data from an Equation Database (Data 6), for example.

Optional Block 6, indicated by reference sign 108, describes rendering a representation of estimated output power on a display device. Alternatively or in addition, the estimated output power may be used for further calculations, for controlling components of an industrial process or other uses already mentioned above.

Reference sign 109 indicates the input data for Block 1, i.e., historical measurement data. Reference sign 110 indicates the input data for Block 2, i.e., recent measurement data. Reference sign 111 indicates the input data for Decision 1, i.e., a predetermined maximum allowed distance to surface. Reference sign 112 indicates the input data for Decision 2, e.g., a Model Database where available motor models are stored. Reference sign 113 indicates the input data for Block 4 and Block 5, i.e., remaining measurement values that remain after discarding measurement values in Block 3. Reference sign 114 indicates input data for Block 5, e.g. data from an equation database, for estimating power when no motor model is available.

While the invention has been illustrated and described in detail in the drawings and foregoing description, such illustration and description are to be considered exemplary and not restrictive. The invention is not limited to the disclosed embodiments. In view of the foregoing description and drawings it will be evident to a person skilled in the art that various modifications may be made within the scope of the invention, as defined by the claims.

## Claims

1. System (1) for obtaining an estimated output power of an electric motor (2), the system (1) comprising a processing unit (3) wherein
the processing unit (3) is configured to
obtain the estimated output power by performing an output power estimation on the basis of data measured by condition monitoring sensors (5a, 5b), the data including vibration measurement data and magnetic flux density measurement data, **characterised in that** the processing unit (3) is further configured to
estimate speed values and line frequency values from the vibration measurement data and magnetic flux density measurement data to obtain estimated speed values and estimated line frequency values,
determine whether any of the estimated speed values and estimated line frequency values are unreliable,
discard the speed values and line frequency values determined to be unreliable, and
perform the output power estimation on the basis of at least some of the estimated speed values and at least some of the estimated line frequency values that remain after discarding the speed values and line frequency values determined to be unreliable.

2. The system (1) of claim 1, wherein the processing unit (3) is configured to perform the output power estimation only on the basis of the vibration measurement data and magnetic flux density measurement data and/or data derived from the vibration measurement data and magnetic flux density measurement data.

3. The system (1) of claim 2,
wherein the processing unit (3) is configured to use data associated with speed values and line frequency values obtained from historical measurements to determine CGS:MBO
whether any of the estimated speed values and estimated line frequency values are unreliable,
in particular, wherein the processing unit is configured to establish a relation of speed values and line frequency values obtained from historical measurements to a parameter indicative of the strength of a magnetic flux density signal, for example a magnetic flux density root mean square, MFDRMS, or an amplitude of the dominant frequency, and, based on the relation, determine whether any of the speed values and line frequency values are unreliable.

4. The system (1) according to claim 2 or claim 3, wherein determining whether any of the estimated speed values and estimated line frequency values are unreliable comprises:
for a pair of an estimated speed value and an estimated line frequency value, calculating a value of a/the parameter indicative of the strength of a/the magnetic flux density signal, e.g. a/the magnetic flux density root mean square, MFDRMS, or an/the amplitude of the dominant frequency, from the estimated line frequency value and comparing the calculated value of the parameter indicative of the strength of the magnetic flux density signal with an expected value of the parameter indicative of the strength of the magnetic flux density signal for a speed value and a line frequency value that are the same as the estimated speed value and the estimated line frequency value,
in particular, determining the difference between the calculated value of the parameter indicative of the strength of the magnetic flux density signal and the expected value of the parameter indicative of the strength of the magnetic flux density signal and, upon determining that the difference exceeds a given threshold, determining that the estimated speed value and estimated line frequency value are unreliable.

5. The system (1) of any one of claims 2 to 4, wherein the processing unit (3) is configured to determine whether a mathematical model of the electric motor that models the output power based on speed values and line frequency values is available, and,
if it is determined that the mathematical model of the electric motor is available, perform the output power estimation by means of the mathematical model by inputting the at least some of the estimated speed values and the at least some of the estimated line frequency values into the mathematical model, and,
if it is determined that no mathematical model of the electric motor that models the output power based on speed values and line frequency values is available, perform the output power estimation using an equation describing a relationship between a line frequency and the output power of the electric motor.

6. The system (1) of any one of claims 3 to 5, the processing unit (3) configured to determine the relation of speed values and line frequency values obtained from historical measurements to the parameter indicative of the strength of a magnetic flux density signal by performing a plurality of measurements to obtain a plurality of speed values and line frequency values, determining corresponding magnetic flux density values, and performing a fitting step to obtain the parameter indicative of the strength of the magnetic flux density signal as a function of speed and line frequency,
in particular, wherein the processing unit is configured to determine a/the expected value of the parameter indicative of the strength of the magnetic flux density signal based on the relation.

7. Computer-implemented method for obtaining an estimated output power of an electric motor (2), for example using the system (1) of one of the preceding claims, wherein the estimated output power is obtained by performing an output power estimation on the basis of data measured by condition monitoring sensors (5a, 5b), the data including vibration measurement data and magnetic flux density measurement data, and **characterised in that**
the method further comprising
estimating speed values and line frequency values from the vibration measurement data and magnetic flux density measurement data so as to obtain estimated speed values and estimated line frequency values,
determining whether any of the estimated speed values and estimated line frequency values are unreliable,
discarding the speed values and line frequency values determined to be unreliable, and
performing the output power estimation on the basis of at least some of the estimated speed values and at least some of the estimated line frequency values that remain after discarding the speed values and line frequency values determined to be unreliable.

8. The method of claim 7, the method further comprising
performing the output power estimation only on the basis of the vibration measurement data and magnetic flux density measurement data and/or data derived from the vibration measurement data and magnetic flux density measurement data.

9. The method of claim 8, further comprising
using data associated with speed values and line frequency values obtained from historical measurements to determine whether any of the estimated speed values and estimated line frequency values are unreliable,
in particular, establishing a relation of speed values and line frequency values obtained from historical measurements to a parameter indicative of the strength of a magnetic flux density signal, for example a magnetic flux density root mean square, MFDRMS, or an amplitude of the dominant frequency, and, based on the relation, determining whether any of the speed values and line frequency values are unreliable

10. The method of claim 8 or claim 9, wherein determining whether any of the estimated speed values and estimated line frequency values are unreliable comprises:
for a pair of an estimated speed value and an estimated line frequency value, calculating a value of a/the parameter indicative of the strength of a/the magnetic flux density signal, e.g. a/the magnetic flux density root mean square, MFDRMS, or an/the amplitude of the dominant frequency, from the estimated line frequency value and comparing the calculated value of the parameter indicative of the strength of the magnetic flux density signal with an expected value of the parameter indicative of the strength of the magnetic flux density signal for a speed value and a line frequency value that are the same as the estimated speed value and the estimated line frequency value,
in particular, determining the difference between the calculated value of the parameter indicative of the strength of the magnetic flux density signal and the expected value of the parameter indicative of the strength of the magnetic flux density signal and, upon determining that the difference exceeds a given threshold, determining that the estimated speed value and estimated line frequency value are unreliable.

11. The method of any one of claims 8 to 10, further comprising
determining whether a mathematical model of the electric motor that models the output power based on speed values and line frequency values is available, and,
if it is determined that the mathematical model is available, performing the output power estimation by means of the mathematical model by inputting the at least some of the estimated speed values and the at least some of the estimated line frequency values into the mathematical model, and,
if it is determined that no mathematical model of the electric motor that models the output power based on speed values and line frequency values is available, performing the output power estimation using an equation describing a relationship between a line frequency and the output power of the electric motor.

12. The method of any one of claims 9 to 11, wherein determining the relation of speed values and line frequency values obtained from historical measurements to the parameter indicative of the strength of a magnetic flux density signal comprises: performing a plurality of measurements to obtain a plurality of speed values and line frequency values, determining corresponding magnetic flux density values, and performing a fitting step to obtain the parameter indicative of the strength of the magnetic flux density signal as a function of speed and line frequency,
in particular, the method comprising determining a/the expected value of the parameter indicative of the strength of the magnetic flux density signal based on the relation.

13. The method of any one of claims 7 to 12, further comprising displaying a representation of the estimated output power on a display device and/or using the estimated output power for subsequent calculation and/or using the estimated output power for controlling the electric motor and/or using the estimated output power for controlling other components and/or saving the estimated output power in a memory device and/or raising an alarm in response to the estimated output power exceeding a first predetermined threshold and/or being below a second predetermined threshold.

14. A computer program product comprising instructions which, when the program is executed by a computer, cause the computer to carry out the method of any one of claims 7 to 13.

15. A computer-readable medium comprising instructions which, when executed by a computer, cause the computer to carry out the method of any one of claims 7 to 13.

## Patentansprüche

1. System (1) zum Erhalten einer geschätzten Ausgangsleistung eines Elektromotors (2), wobei das System (1) eine Verarbeitungseinheit (3) umfasst, wobei die Verarbeitungseinheit (3) konfiguriert ist, die geschätzte Ausgangsleistung durch Durchführung einer Ausgangsleistungsschätzung auf Basis von durch Zustandsüberwachungssensoren (5a, 5b) gemessenen Daten zu erhalten, wobei die Daten Schwingungsmessdaten und Messdaten der magnetischen Flussdichte umfassen, **dadurch gekennzeichnet, dass** die Verarbeitungseinheit (3) ferner konfiguriert ist, Geschwindigkeitswerte und Netzfrequenzwerte aus den Schwingungsmessdaten und den Messdaten der magnetischen Flussdichte zu schätzen, um geschätzte Geschwindigkeitswerte und geschätzte Netzfrequenzwerte zu erhalten, zu bestimmen, ob einer der geschätzten Geschwindigkeitswerte und geschätzten Netzfrequenzwerte unzuverlässig ist, die als unzuverlässig bestimmten Geschwindigkeitswerte und Netzfrequenzwerte zu verwerfen und die Ausgangsleistungsschätzung auf Basis von zumindest einigen der geschätzten Geschwindigkeitswerte und zumindest einigen der geschätzten Netzfrequenzwerte durchzuführen, die nach dem Verwerfen der als unzuverlässig bestimmten Werte verbleiben.

2. System (1) nach Anspruch 1, wobei die Verarbeitungseinheit (3) konfiguriert ist, die Ausgangsleistungsschätzung ausschließlich auf Basis der Schwingungsmessdaten und der Messdaten der magnetischen Flussdichte und/oder der aus den Schwingungsmessdaten und den Messdaten der magnetischen Flussdichte abgeleiteten Daten durchzuführen.

3. System (1) nach Anspruch 2, wobei die Verarbeitungseinheit (3) konfiguriert ist, Daten, die mit aus historischen Messungen erhaltenen Geschwindigkeitswerten und Netzfrequenzwerten assoziiert sind, zu verwenden, um zu bestimmen, ob einer der geschätzten Geschwindigkeitswerte und geschätzten Netzfrequenzwerte unzuverlässig ist, insbesondere wobei die Verarbeitungseinheit konfiguriert ist, eine Beziehung zwischen aus historischen Messungen erhaltenen Geschwindigkeitswerten und Netzfrequenzwerten und einem Parameter, der die Stärke eines magnetischen Flussdichtesignals anzeigt, beispielsweise einem Effektivwert der magnetischen Flussdichte (MFDRMS) oder einer Amplitude der dominanten Frequenz, herzustellen und basierend auf dieser Beziehung zu bestimmen, ob einer der Werte unzuverlässig ist.

4. System (1) nach Anspruch 2 oder 3, wobei das Bestimmen, ob einer der geschätzten Geschwindigkeitswerte und geschätzten Netzfrequenzwerte unzuverlässig ist, Folgendes umfasst:
für ein Paar aus einem geschätzten Geschwindigkeitswert und einem geschätzten Netzfrequenzwert einen Wert eines/ des Parameters, der die Stärke eines/ des magnetischen Flussdichtesignals anzeigt, z. B. einen/ den Effektivwert der magnetischen Flussdichte, MFDRMS, oder eine/ die Amplitude der dominanten Frequenz, aus dem geschätzten Netzfrequenzwert zu berechnen und den berechneten Wert des Parameters, der die Stärke des magnetischen Flussdichtesignals anzeigt, mit einem erwarteten Wert des Parameters, der die Stärke des magnetischen Flussdichtesignals für einen Geschwindigkeitswert und einen Netzfrequenzwert anzeigt, die mit dem geschätzten Geschwindigkeitswert und dem geschätzten Netzfrequenzwert übereinstimmen, zu vergleichen,
insbesondere die Differenz zwischen dem berechneten Wert des Parameters, der die Stärke des magnetischen Flussdichtesignals anzeigt, und dem erwarteten Wert des Parameters, der die Stärke des magnetischen Flussdichtesignals anzeigt, zu bestimmen und, falls festgestellt wird, dass die Differenz einen vorgegebenen Schwellenwert überschreitet, zu bestimmen, dass der geschätzte Geschwindigkeitswert und der geschätzte Netzfrequenzwert unzuverlässig sind.

5. System (1) nach einem der Ansprüche 2 bis 4, wobei die Verarbeitungseinheit (3) konfiguriert ist, zu bestimmen, ob ein mathematisches Modell des Elektromotors verfügbar ist, das die Ausgangsleistung basierend auf Geschwindigkeitswerten und Netzfrequenzwerten modelliert, und
wenn festgestellt wird, dass ein solches mathematisches Modell des Elektromotors verfügbar ist, die Ausgangsleistungsschätzung mittels des mathematischen Modells durchzuführen, indem zumindest einige der geschätzten Geschwindigkeitswerte und zumindest einige der geschätzten Netzfrequenzwerte in das mathematische Modell eingegeben werden, und
wenn festgestellt wird, dass kein mathematisches Modell des Elektromotors, das die Ausgangsleistung basierend auf Geschwindigkeitswerten und Netzfrequenzwerten modelliert, verfügbar ist, die Ausgangsleistungsschätzung unter Verwendung einer Gleichung durchzuführen, welche eine Beziehung zwischen einer Netzfrequenz und der Ausgangsleistung des Elektromotors beschreibt.

6. System (1) nach einem der Ansprüche 3 bis 5, wobei die Verarbeitungseinheit (3) konfiguriert ist, die Beziehung zwischen aus historischen Messungen erhaltenen Geschwindigkeitswerten und Netzfrequenzwerten und dem Parameter, der die Stärke eines magnetischen Flussdichtesignals anzeigt, durch Durchführung einer Vielzahl von Messungen zum Erhalten einer Vielzahl von Geschwindigkeitswerten und Netzfrequenzwerten, Bestimmen entsprechender magnetischer Flussdichtewerte und Durchführung eines Anpassungsschritts zum Erhalten des Parameters als Funktion von Geschwindigkeit und Netzfrequenz zu bestimmen,
insbesondere wobei die Verarbeitungseinheit konfiguriert ist, einen/den erwarteten Wert des Parameters, der die Stärke eines magnetischen Flussdichtesignals anzeigt, basierend auf der Beziehung zu bestimmen.

7. Computerimplementiertes Verfahren zum Erhalten einer geschätzten Ausgangsleistung eines Elektromotors (2), beispielsweise unter Verwendung des Systems (1) nach einem der vorhergehenden Ansprüche, wobei die geschätzte Ausgangsleistung durch Durchführung einer Ausgangsleistungsschätzung auf Basis von durch Zustandsüberwachungssensoren (5a, 5b) gemessenen Daten, wobei die Daten Schwingungsmessdaten und Messdaten der magnetischen Flussdichte umfassen, erhalten wird, und **dadurch gekennzeichnet ist, dass** das Verfahren ferner umfasst
Schätzen von Geschwindigkeitswerten und Netzfrequenzwerten aus den Schwingungsmessdaten und den Messdaten der magnetischen Flussdichte, um geschätzte Geschwindigkeitswerte und geschätzte Netzfrequenzwerte zu erhalten, Bestimmen, ob einer der geschätzten Geschwindigkeitswerte und geschätzten Netzfrequenzwerte unzuverlässig ist, Verwerfen der als unzuverlässig bestimmten Geschwindigkeitswerte und Netzfrequenzwerte, und Durchführen der Ausgangsleistungsschätzung auf Basis von zumindest einigen der geschätzten Geschwindigkeitswerte und zumindest einigen der geschätzten Netzfrequenzwerte, die nach dem Verwerfen der als unzuverlässig bestimmten Werte verbleiben.

8. Verfahren nach Anspruch 7, wobei das Verfahren ferner umfasst
die Ausgangsleistungsschätzung ausschließlich auf Basis der Schwingungsmessdaten und der Messdaten der magnetischen Flussdichte und/oder aus den Schwingungsmessdaten und den Messdaten der magnetischen Flussdichte abgeleiteten Daten durchzuführen.

9. Verfahren nach Anspruch 8, wobei das Verfahren ferner umfasst, Daten, die mit aus historischen Messungen erhaltenen Geschwindigkeitswerten und Netzfrequenzwerten assoziiert sind, zu verwenden, um zu bestimmen, ob einer der geschätzten Geschwindigkeitswerte und geschätzten Netzfrequenzwerte unzuverlässig ist,
insbesondere eine Beziehung zwischen aus historischen Messungen erhaltenen Geschwindigkeitswerten und Netzfrequenzwerten und einem Parameter, der die Stärke eines magnetischen Flussdichtesignals anzeigt, beispielsweise einem Effektivwert der magnetischen Flussdichte, MFDRMS, oder einer Amplitude der dominanten Frequenz, herzustellen und basierend auf dieser Beziehung zu bestimmen, ob einer der Geschwindigkeitswerte und Netzfrequenzwerte unzuverlässig ist.

10. Verfahren nach Anspruch 8 oder 9, wobei das Bestimmen, ob einer der geschätzten Geschwindigkeitswerte und geschätzten Netzfrequenzwerte unzuverlässig ist, Folgendes umfasst:
für ein Paar aus einem geschätzten Geschwindigkeitswert und einem geschätzten Netzfrequenzwert einen Wert eines/ des Parameters, der die Stärke eines/ des magnetischen Flussdichtesignals anzeigt, z. B. einen/ den Effektivwert der magnetischen Flussdichte, MFDRMS, oder eine/ die Amplitude der dominanten Frequenz, aus dem geschätzten Netzfrequenzwert zu berechnen und den berechneten Wert des Parameters, der die Stärke des magnetischen Flussdichtesignals anzeigt, mit einem erwarteten Wert des Parameters, der die Stärke des magnetischen Flussdichtesignals für einen Geschwindigkeitswert und einen Netzfrequenzwert anzeigt, die mit dem geschätzten Geschwindigkeitswert und dem geschätzten Netzfrequenzwert übereinstimmen, zu vergleichen, insbesondere die Differenz zwischen dem berechneten Wert des Parameters, der die Stärke des magnetischen Flussdichtesignals anzeigt, und dem erwarteten Wert des Parameters, der die Stärke des magnetischen Flussdichtesignals anzeigt, zu bestimmen und, falls festgestellt wird, dass die Differenz einen vorgegebenen Schwellenwert überschreitet, zu bestimmen, dass der geschätzte Geschwindigkeitswert und der geschätzte Netzfrequenzwert unzuverlässig sind.

11. Verfahren nach einem der Ansprüche 8 bis 10, wobei das Verfahren ferner umfasst, zu bestimmen, ob ein mathematisches Modell des Elektromotors, das die Ausgangsleistung basierend auf Geschwindigkeitswerten und Netzfrequenzwerten modelliert, verfügbar ist, und, falls bestimmt wird, dass das mathematische Modell verfügbar ist, die Ausgangsleistungsschätzung mittels des mathematischen Modells durchzuführen, indem zumindest einige der geschätzten Geschwindigkeitswerte und zumindest einige der geschätzten Netzfrequenzwerte in das mathematische Modell eingegeben werden, und, falls bestimmt wird, dass kein mathematisches Modell des Elektromotors, das die Ausgangsleistung basierend auf Geschwindigkeitswerten und Netzfrequenzwerten modelliert, verfügbar ist, die Ausgangsleistungsschätzung unter Verwendung einer Gleichung, die eine Beziehung zwischen einer Netzfrequenz und der Ausgangsleistung des Elektromotors beschreibt, durchzuführen.

12. Verfahren nach einem der Ansprüche 9 bis 11, wobei das Bestimmen der Beziehung zwischen aus historischen Messungen erhaltenen Geschwindigkeitswerten und Netzfrequenzwerten und dem Parameter, der die Stärke eines magnetischen Flussdichtesignals anzeigt, Folgendes umfasst: Durchführung einer Vielzahl von Messungen zum Erhalten einer Vielzahl von Geschwindigkeitswerten und Netzfrequenzwerten, Bestimmen entsprechender magnetischer Flussdichtewerte und Durchführung eines Anpassungsschritts zum Erhalten des Parameters als Funktion von Geschwindigkeit und Netzfrequenz,
insbesondere umfasst das Verfahren das Bestimmen eines/ des erwarteten Wertes des Parameters, der die Stärke eines magnetischen Flussdichtesignals anzeigt, basierend auf der Beziehung.

13. Verfahren nach einem der Ansprüche 7 bis 12, wobei das Verfahren ferner umfasst, eine Darstellung der geschätzten Ausgangsleistung auf einem Anzeigegerät anzuzeigen und/oder die geschätzte Ausgangsleistung für eine nachfolgende Berechnung zu verwenden und/oder die geschätzte Ausgangsleistung zur Steuerung des Elektromotors und/oder zur Steuerung anderer Komponenten zu verwenden und/oder die geschätzte Ausgangsleistung in einem Speichergerät zu speichern und/oder einen Alarm auszulösen, wenn die geschätzte Ausgangsleistung einen ersten vorbestimmten Schwellenwert überschreitet und/oder unter einen zweiten vorbestimmten Schwellenwert fällt.

14. Computerprogrammprodukt, das Anweisungen umfasst, die, wenn das Programm von einem Computer ausgeführt wird, den Computer veranlassen, das Verfahren nach einem der Ansprüche 7 bis 13 durchzuführen.

15. Computerlesbares Medium, das Anweisungen umfasst, die, wenn sie von einem Computer ausgeführt werden, den Computer veranlassen, das Verfahren nach einem der Ansprüche 7 bis 13 durchzuführen.

## Revendications

1. Système (1) pour obtenir une puissance de sortie estimée d'un moteur électrique (2), le système (1) comprenant une unité de traitement (3), dans lequel l'unité de traitement (3) est configurée pour obtenir la puissance de sortie estimée en réalisant une estimation de puissance de sortie sur la base de données mesurées par des capteurs de surveillance d'état (5a, 5b), les données incluant des données de mesure de vibration et des données de mesure de densité de flux magnétique, **caractérisé en ce que** l'unité de traitement (3) est en outre configurée pour estimer des valeurs de vitesse et des valeurs de fréquence de ligne à partir des données de mesure de vibration et des données de mesure de densité de flux magnétique pour obtenir des valeurs de vitesse estimées et des valeurs de fréquence de ligne estimées, déterminer si certaines des valeurs de vitesse estimées et des valeurs de fréquence de ligne estimées ne sont pas fiables,
éliminer les valeurs de vitesse et les valeurs de fréquence de ligne déterminées comme n'étant pas fiables, et
réaliser l'estimation de puissance de sortie sur la base d'au moins certaines des valeurs de vitesse estimées et d'au moins certaines des valeurs de fréquence de ligne estimées qui restent après l'élimination des valeurs de vitesse et des valeurs de fréquence de ligne déterminées comme n'étant pas fiables.

2. Système (1) selon la revendication 1, dans lequel l'unité de traitement (3) est configurée pour réaliser l'estimation de puissance de sortie uniquement sur la base des données de mesure de vibration et des données de mesure de densité de flux magnétique et/ou de données dérivées des données de mesure de vibration et des données de mesure de densité de flux magnétique.

3. Système (1) selon la revendication 2,
dans lequel l'unité de traitement (3) est configurée pour utiliser des données associées à des valeurs de vitesse et des valeurs de fréquence de ligne obtenues à partir de mesures historiques pour déterminer si certaines des valeurs de vitesse estimées et des valeurs de fréquence de ligne estimées ne sont pas fiables,
en particulier, dans lequel l'unité de traitement est configurée pour établir une relation de valeurs de vitesse et de valeurs de fréquence de ligne obtenues à partir de mesures historiques avec un paramètre indicatif de l'intensité d'un signal de densité de flux magnétique, par exemple une moyenne quadratique de densité de flux magnétique, MFDRMS, ou une amplitude de la fréquence dominante, et, sur la base de la relation, déterminer si certaines des valeurs de vitesse et des valeurs de fréquence de ligne ne sont pas fiables.

4. Système (1) selon la revendication 2 ou la revendication 3, dans lequel le fait de déterminer si certaines des valeurs de vitesse estimées et des valeurs de fréquence de ligne estimées ne sont pas fiables comprend :
pour une paire d'une valeur de vitesse estimée et d'une valeur de fréquence de ligne estimée, le calcul d'une valeur d'un/du paramètre indicatif de l'intensité d'un/du signal de densité de flux magnétique, par exemple une/la moyenne quadratique de densité de flux magnétique, MFDRMS, ou une/l'amplitude de la fréquence dominante, à partir de la valeur de fréquence de ligne estimée et la comparaison de la valeur calculée du paramètre indicatif de l'intensité du signal de densité de flux magnétique avec une valeur attendue du paramètre indicatif de l'intensité du signal de densité de flux magnétique pour une valeur de vitesse et une valeur de fréquence de ligne qui sont identiques à la valeur de vitesse estimée et à la valeur de fréquence de ligne estimée,
en particulier, la détermination de la différence entre la valeur calculée du paramètre indicatif de l'intensité du signal de densité de flux magnétique et la valeur attendue du paramètre indicatif de l'intensité du signal de densité de flux magnétique et, lorsqu'il est déterminé que la différence dépasse un seuil donné, la détermination du fait que la valeur de vitesse estimée et la valeur de fréquence de ligne estimée ne sont pas fiables.

5. Système (1) selon l'une quelconque des revendications 2 à 4, dans lequel l'unité de traitement (3) est configurée pour déterminer si un modèle mathématique du moteur électrique qui modélise la puissance de sortie sur la base de valeurs de vitesse et de valeurs de fréquence de ligne est disponible, et, s'il est déterminé que le modèle mathématique du moteur électrique est disponible, réaliser l'estimation de puissance de sortie au moyen du modèle mathématique en entrant les au moins certaines des valeurs de vitesse estimées et les au moins certaines des valeurs de fréquence de ligne estimées dans le modèle mathématique, et,
s'il est déterminé qu'aucun modèle mathématique du moteur électrique qui modélise la puissance de sortie sur la base de valeurs de vitesse et de valeurs de fréquence de ligne n'est disponible, réaliser l'estimation de puissance de sortie en utilisant une équation décrivant une relation entre une fréquence de ligne et la puissance de sortie du moteur électrique.

6. Système (1) selon l'une quelconque des revendications 3 à 5, l'unité de traitement (3) étant configurée pour déterminer la relation de valeurs de vitesse et de valeurs de fréquence de ligne obtenues à partir de mesures historiques avec le paramètre indicatif de l'intensité d'un signal de densité de flux magnétique en réalisant une pluralité de mesures pour obtenir une pluralité de valeurs de vitesse et de valeurs de fréquence de ligne, en déterminant des valeurs de densité de flux magnétique correspondantes, et en réalisant une étape d'ajustement pour obtenir le paramètre indicatif de l'intensité du signal de densité de flux magnétique en fonction de la vitesse et de la fréquence de ligne, en particulier, dans lequel l'unité de traitement est configurée pour déterminer une/la valeur attendue du paramètre indicatif de l'intensité du signal de densité de flux magnétique sur la base de la relation.

7. Procédé mis en œuvre par ordinateur pour obtenir une puissance de sortie estimée d'un moteur électrique (2), par exemple en utilisant le système (1) selon l'une des revendications précédentes, dans lequel la puissance de sortie estimée est obtenue en réalisant une estimation de puissance de sortie sur la base de données mesurées par des capteurs de surveillance d'état (5a, 5b), les données incluant des données de mesure de vibration et des données de mesure de densité de flux magnétique, et **caractérisé en ce que**
le procédé comprend en outre :
l'estimation de valeurs de vitesse et de valeurs de fréquence de ligne à partir des données de mesure de vibration et des données de mesure de densité de flux magnétique de manière à obtenir des valeurs de vitesse estimées et des valeurs de fréquence de ligne estimées, le fait de déterminer si certaines des valeurs de vitesse estimées et des valeurs de fréquence de ligne estimées ne sont pas fiables,
l'élimination des valeurs de vitesse et des valeurs de fréquence de ligne déterminées comme n'étant pas fiables, et
la réalisation de l'estimation de puissance de sortie sur la base d'au moins certaines des valeurs de vitesse estimées et d'au moins certaines des valeurs de fréquence de ligne estimées qui restent après l'élimination des valeurs de vitesse et des valeurs de fréquence de ligne déterminées comme n'étant pas fiables.

8. Procédé de la revendication 7, le procédé comprenant en outre
la réalisation de l'estimation de puissance de sortie uniquement sur la base des données de mesure de vibration et des données de mesure de densité de flux magnétique et/ou de données dérivées des données de mesure de vibration et des données de mesure de densité de flux magnétique.

9. Procédé selon la revendication 8, comprenant en outre
l'utilisation de données associées à des valeurs de vitesse et des valeurs de fréquence de ligne obtenues à partir de mesures historiques pour déterminer si certaines des valeurs de vitesse estimées et des valeurs de fréquence de ligne estimées ne sont pas fiables,
en particulier, l'établissement d'une relation de valeurs de vitesse et de valeurs de fréquence de ligne obtenues à partir de mesures historiques avec un paramètre indicatif de l'intensité d'un signal de densité de flux magnétique, par exemple une moyenne quadratique de densité de flux magnétique, MFDRMS, ou une amplitude de la fréquence dominante, et, sur la base de la relation, le fait de déterminer si certaines des valeurs de vitesse et des valeurs de fréquence de ligne ne sont pas fiables.

10. Procédé selon la revendication 8 ou la revendication 9, dans lequel le fait de déterminer si certaines des valeurs de vitesse estimées et des valeurs de fréquence de ligne estimées ne sont pas fiables comprend :
pour une paire d'une valeur de vitesse estimée et d'une valeur de fréquence de ligne estimée, le calcul d'une valeur d'un/du paramètre indicatif de l'intensité d'un/du signal de densité de flux magnétique, par exemple une/la moyenne quadratique de densité de flux magnétique, MFDRMS, ou une/l'amplitude de la fréquence dominante, à partir de la valeur de fréquence de ligne estimée et la comparaison de la valeur calculée du paramètre indicatif de l'intensité du signal de densité de flux magnétique avec une valeur attendue du paramètre indicatif de l'intensité du signal de densité de flux magnétique pour une valeur de vitesse et une valeur de fréquence de ligne qui sont identiques à la valeur de vitesse estimée et à la valeur de fréquence de ligne estimée,
en particulier, la détermination de la différence entre la valeur calculée du paramètre indicatif de l'intensité du signal de densité de flux magnétique et la valeur attendue du paramètre indicatif de l'intensité du signal de densité de flux magnétique et, lorsqu'il est déterminé que la différence dépasse un seuil donné, la détermination du fait que la valeur de vitesse estimée et la valeur de fréquence de ligne estimée ne sont pas fiables.

11. Procédé selon l'une quelconque des revendications 8 à 10, comprenant en outre
le fait de déterminer si un modèle mathématique du moteur électrique qui modélise la puissance de sortie sur la base de valeurs de vitesse et de valeurs de fréquence de ligne est disponible, et,
s'il est déterminé que le modèle mathématique est disponible, la réalisation de l'estimation de puissance de sortie au moyen du modèle mathématique en entrant les au moins certaines des valeurs de vitesse estimées et les au moins certaines des valeurs de fréquence de ligne estimées dans le modèle mathématique, et,
s'il est déterminé qu'aucun modèle mathématique du moteur électrique qui modélise la puissance de sortie sur la base de valeurs de vitesse et de valeurs de fréquence de ligne n'est disponible, la réalisation de l'estimation de puissance de sortie en utilisant une équation décrivant une relation entre une fréquence de ligne et la puissance de sortie du moteur électrique.

12. Procédé selon l'une quelconque des revendications 9 à 11, dans lequel la détermination de la relation de valeurs de vitesse et de valeurs de fréquence de ligne obtenues à partir de mesures historiques avec le paramètre indicatif de l'intensité d'un signal de densité de flux magnétique comprend : la réalisation d'une pluralité de mesures pour obtenir une pluralité de valeurs de vitesse et de valeurs de fréquence de ligne, la détermination de valeurs de densité de flux magnétique correspondantes, et la réalisation d'une étape d'ajustement pour obtenir le paramètre indicatif de l'intensité du signal de densité de flux magnétique en fonction de la vitesse et de la fréquence de ligne,
en particulier, le procédé comprenant la détermination d'une/de la valeur attendue du paramètre indicatif de l'intensité du signal de densité de flux magnétique sur la base de la relation.

13. Procédé selon l'une quelconque des revendications 7 à 12, comprenant en outre l'affichage d'une représentation de la puissance de sortie estimée sur un dispositif d'affichage et/ou l'utilisation de la puissance de sortie estimée pour un calcul ultérieur et/ou l'utilisation de la puissance de sortie estimée pour commander le moteur électrique et/ou l'utilisation de la puissance de sortie estimée pour commander d'autres composants et/ou l'enregistrement de la puissance de sortie estimée dans un dispositif de mémoire et/ou le déclenchement d'une alarme en réponse au fait que la puissance de sortie estimée dépasse un premier seuil prédéterminé et/ou est inférieure à un second seuil prédéterminé.

14. Produit programme informatique comprenant des instructions, qui, lorsque le programme est exécuté par un ordinateur, amènent l'ordinateur à mettre en œuvre le procédé selon l'une quelconque des revendications 7 à 13.

15. Support lisible par ordinateur comprenant des instructions qui, lorsqu'elles sont exécutées par un ordinateur, amènent l'ordinateur à mettre en œuvre le procédé selon l'une quelconque des revendications 7 à 13.
